# FASCICULE DE BREVET EUROPEEN

(11) **EP 0 562 962 B1**
(45) Date de publication et mention de la délivrance du brevet: **30.10.1996**
(21) Numéro de dépôt: 93400765.9
(22) Date de dépôt: 24.03.1993
(51) Int. Cl.: H03G 3/20

(54) **Dispositif de traitement de signaux se présentant sous forme de paquets**
Verfahren zur Verarbeitung von in Datenpaketen übertragenen Signalen
Device for processing signals transmitted as data packets

(30) Priorité: 27.03.1992 FR 9203755
(43) Date de publication de la demande: 29.09.1993
(73) Titulaire: ALCATEL TELSPACE, 92734 Nanterre Cédex (FR)
(72) Inventeur: Lopez, Pierre, F-92300 Levaillois-Perret (FR); Podolak, Thierry, F-92300 Levaillois-Perret (FR)
(74) Mandataire: Pothet, Jean Rémy Emile Ludovic

(56) Documents cités:
- US-A- 4 330 859
- US-A- 4 551 688
- US-A- 4 574 252

## Description

Le domaine de l'invention est celui des dispositifs de traitement de signaux se présentant sous forme de paquets, et concerne particulièrement ceux de ces dispositifs dans lesquels il est fait usage d'un élément de traitement ayant des effets secondaires susceptibles d'engendrer des perturbations affectant des paquets adjacents.

On trouvera de tels dispositifs, par exemple, dans les récepteurs de systèmes dits à "Accès Multiples à Répartition dans le temps", ou AMRT. Un système AMRT est par exemple appliqué dans le système de radiotéléphonie cellulaire numérique dit GSM. Dans un tel système, des stations mobiles communiquent par voie hertzienne avec des stations fixes, dites stations de base, qui sont connectées au réseau de télécommunications classique. La communication entre une station fixe et des stations mobiles qui se trouvent dans sa zone de couverture a lieu sur un canal de fréquence bilatéral partagé entre plusieurs stations mobiles par division dans le temps, un intervalle de temps d'une trame répétitive étant alloué à chaque station mobile. L'ensemble des intervalles de temps de ces trames répétitives, qui est ainsi alloué à une station mobile, est souvent appelé voie temporelle. Dans le sens station mobile vers station fixe, chaque station mobile transmet un paquet d'information dans chaque intervalle de temps qui lui est alloué, avec le niveau qui lui est propre. A la réception dans la station fixe, les paquets en provenance de diverses stations mobiles, qui se suivent dans les intervalles de temps de chaque trame, n'ont pas tous la même amplitude. En raison de conditions de propagation variées (distances différentes, obstacles, etc.), ils ont des amplitudes qui se distribuent dans ce qu'il est convenu d'appeler une forte dynamique. Il est nécessaire de compenser de telles différences de niveau à l'entrée du récepteur de la station fixe.

Une solution proposée par la demanderesse dans la demande de brevet français n°92.03754, déposée le même jour que la présente et ayant pour titre "Dispositif de commande de gain dans un récepteur de signaux d'information", prévoit l'emploi de moyens d'amplification à facteur d'amplification ajustable, de moyens d'évaluation pour recevoir le signal d'entrée et en dériver un signal d'amplitude, de moyens de traitement couplés aux moyens d'évaluation, recevant le signal d'amplitude et en dérivant un signal de commande de gain, lequel est transmis à une entrée de commande de gain des moyens d'amplification, ainsi qu'une ligne à retard interposée entre l'entrée de signal et les moyens d'amplification, la ligne à retard fournissant à ces derniers un signal d'entrée retardé tel que le signal de commande de gain est disponible pour la commande de gain dans les moyens d'amplification au moment où ceux-ci reçoivent le signal d'entrée retardé.

De plus, le dispositif de commande de gain de cette solution comprend un filtre agencé pour que le signal d'entrée soit filtré, par un filtre passe-bande notamment.

La ligne à retard et le filtre que l'on vient de mentionner sont deux exemples d'éléments de traitement ayant des effets secondaires susceptibles d'engendrer des perturbations affectant des paquets adjacents.

En effet, une ligne à retard présente un certain couplage, indésirable, entre son entrée et sa sortie. Si la ligne à retard achemine des paquets consécutifs, selon le système décrit, le début d'un paquet risque de perturber la fin du paquet précédent.

De plus, une ligne à retard, quand il s'agit d'une ligne à retard analogique passive, présente un autre effet indésirable qui est l'acheminement multiple d'un signal par réflexion de ce signal sur la sortie, traversée de la ligne en arrière, réflexion sur l'entrée et nouvelle traversée en avant, jusqu'à la sortie qui fournit ainsi non seulement le signal d'entrée retardé une fois par la ligne, mais aussi une réplique atténuée, retardée trois fois par la ligne, qui risque de perturber le début du paquet suivant.

Un filtre analogique à bande étroite, tel qu'un filtre à quartz, présente quant à lui un phénomène de sur-oscillation prolongeant un paquet et risquant de perturber le début du paquet suivant.

Bien entendu, on peut réduire au point de rendre acceptables de tels effets secondaires indésirables, mais cela demande des précautions coûteuses.

Par ailleurs, le cas que l'on vient d'évoquer de la réception de signaux dans un systèmes AMRT tel que le système GSM ne constitue bien sûr qu'un exemple et l'homme de métier connaît bien d'autres cas de traitement de signaux se présentant sous la forme de paquets successifs où se rencontre le même problème.

La présente invention apporte à ce problème une solution efficace, simple et peu onéreuse.

A cet effet, la présente invention propose un dispositif de traitement de signaux se présentant sous forme de paquets successifs, transmis dans des intervalles de temps successifs, du type comprenant une chaîne de traitement incluant au moins un élément de traitement à effets secondaires susceptible d'engendrer des perturbations affectant des paquets adjacents. Ce dispositif se caractérise en ce qu'il comprend au moins deux éléments de traitement à effets secondaires disposés dans des voies séparées, ainsi que des moyens de commutation connectant cycliquement les voies séparées à une entrée de paquets et à une sortie de paquet, chacune durant un intervalle de temps, et les déconnectant entre temps de cette entrée de paquets et de cette sortie de paquets de façon qu'une voie connectée pour le traitement d'un paquet ne puisse être perturbée par des paquets adjacents, chacun traité par une autre voie.

Une voie séparée qui vient de traiter un paquet est ainsi déconnectée de manière à ne pas perturber les paquets adjacents traités par la ou les autres voies.

Dans la mise en oeuvre de l'invention, les moyens de commutation comprennent un commutateur amont connectant sélectivement et cycliquement l'entrée de paquets à une entrée de l'une de l'ensemble des voies séparées et un commutateur aval connectant sélectivement et cycliquement une sortie de l'une des voies séparées à la sortie de paquets. Les commutateurs avals peuvent accomplir leurs opérations de commutation vers les mêmes voies que les commutateurs amont, mais avec un décalage dans le temps qui correspond au temps de transit des signaux dans une des voies séparées.

Additionnellement et avantageusement, les moyens de commutation sont agencés non seulement pour la connexion sélective de l'une des voies séparées, mais aussi pour fournir à toute voie non sélectionnée une charge dissipative.

Comme mentionné antérieurement, les éléments à effets secondaires comprennent une ligne à retard et/ou un filtre à bande étroite.

Dans une forme de réalisation simple, le nombre des voies séparées est deux et les deux voies séparées sont utilisées alternativement par le moyen de commutateurs inverseurs.

D'autres caractéristiques et avantages de l'invention apparaîtront à la lecture de la description suivante de modes de réalisation donnés à titre d'exemples non-limitatifs, faite en se référant aux figures annexées qui représentent :
- la figure 1, la situation de stations mobiles par rapport à une station fixe, dans un système de type AMRT,
- la figure 2, la trame AMRT reçue par la station fixe dans le cas de la figure 1,
- la figure 3, un mode de réalisation d'un récepteur de signaux d'information dans lequel l'emploi de la présente invention est souhaitable,
- la figure 4, des paquets successifs et les effets secondaires indésirables susceptibles d'être produits par une ligne à retard,
- la figure 5, des paquets successifs et les effets secondaires indésirables susceptibles d'être produits par un filtre très sélectif,
- les figures 6A, 6B, 6C, un dispositif de traitement de signaux conforme à l'invention, dans trois positions de fonctionnement différentes,
- la figure 7, un dispositif de traitement de signaux conforme à l'invention, combinant filtrage et retard, tel que rencontré dans le récepteur de la figure 3.

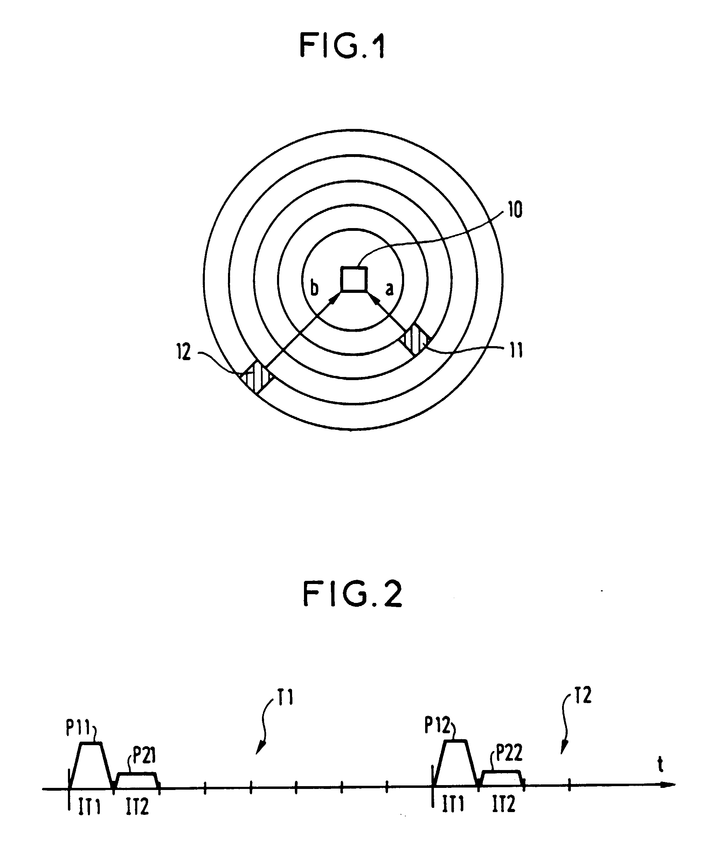

La figure 1 représente un système de transmission incluant une station fixe 10 et deux stations mobiles 11 et 12 situées à des distances différentes a et b de la station de base 10. L'ensemble peut appartenir, par exemple, à un réseau radiotéléphonique tel que le réseau GSM.

Dans ce qui suit, on ne traitera que de la transmission des stations mobiles vers la station fixe. La transmission des stations mobiles vers la station fixe a lieu par paquets dans une trame d'intervalles de temps répétitifs, tel qu'il est représenté à la figure 2 où l'on a représenté une trame T1, composée d'intervalles de temps consécutifs IT1, IT2, etc., et le début d'une trame T2 où l'on retrouve les intervalles de temps IT1 et IT2. Dans le premier des intervalles de temps IT1 de la trame T1, la station mobile 11 transmet un paquet P11, tandis que, dans l'intervalle de temps IT2, la station mobile 12 transmet le paquet P21. Dans le premier intervalle de temps IT1 de la trame T2, la station mobile 11 transmet un nouveau paquet P12, lequel est suivi d'un paquet P22 transmis par la station mobile 12, et ainsi de suite.

Chaque paquet transmis est en fait un signal à une fréquence allouée à la communication entre les stations mobiles considérées et la station fixe, modulé par l'information à transmettre, information numérique dans le cas d'un système de type GSM.

La figure 2 représente les signaux tels qu'ils sont reçus par la station fixe 10. Des dispositions dont on ne traitera pas ici, car elles sont étrangères à la présente invention, peuvent être employées afin que la position temporelle des paquets qui se suivent soit définie de façon appropriée à leur arrivée dans la station fixe.

Le point important est que les paquets reçus de différentes stations mobiles ont des amplitudes variées. La station mobile 11 est en effet relativement proche de la station fixe 10. L'amplitude du signal que reçoit la station fixe 10 dans l'intervalle de temps IT1 est donc relativement importante. Par comparaison, la station mobile 12 est plus éloignée et l'amplitude du signal que reçoit la station fixe 10 dans l'intervalle de temps IT2 est relativement faible.

La distance n'est bien sûr pas le seul facteur qui intervienne dans l'amplitude des signaux reçus par la station fixe 10 ; on peut encore citer la présence d'obstacle à la propagation, l'évanouissement par trajets multiples, etc.

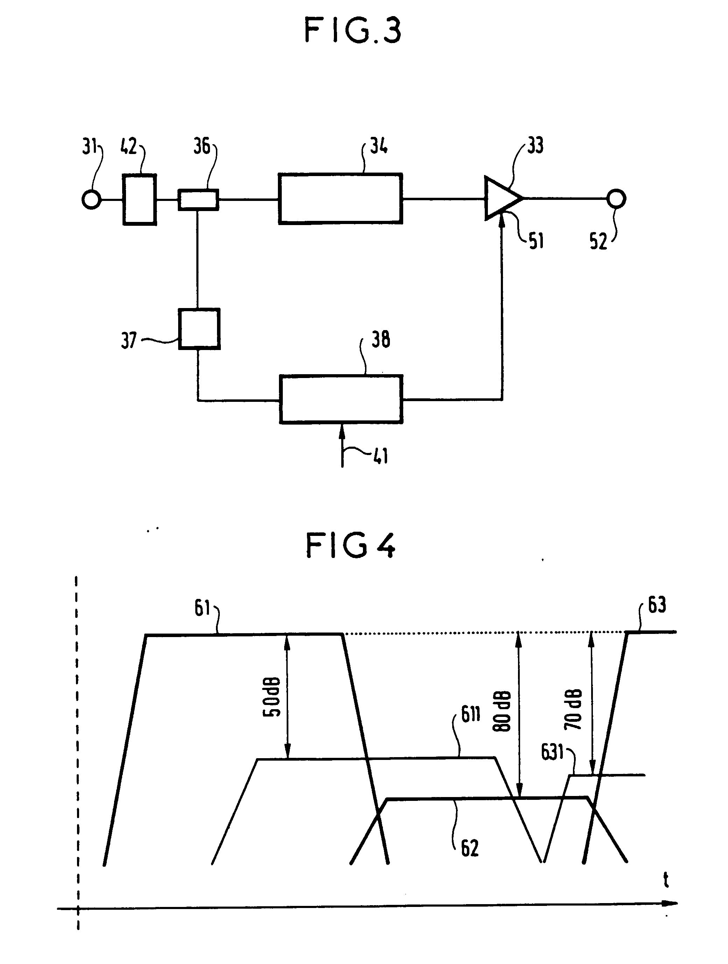

La réception de signaux ayant ainsi une forte dynamique pose un problème de réduction de cette dynamique, avant que ces signaux ne soient exploités, par exemple pour recouvrer l'information analogique ou numérique qu'ils contiennent. Ce problème est traité de façon détaillé dans la demande de brevet conjointe mentionnée précédemment et la solution qui y est proposée est illustrée à la figure 3. Elle représente partiellement un récepteur de signaux comprenant notamment :
- une entrée de signal 31 recevant un signal d'entrée qui peut être le signal d'antenne de la station fixe 10 de la figure 1 tel qu'illustré à la figure 2,
- des moyens d'amplification à facteur d'amplification ajustable 33 couplés à l'entrée 31 pour recevoir le signal d'entrée et en modifier le niveau en fonction d'un signal de commande de gain reçu sur une entrée de commande de gain 51, de manière à en dériver un signal de sortie,
- une sortie de signal 52 couplée aux moyens d'amplification 33 et fournissant le signal de sortie,
- des moyens d'évaluation 37 couplés à l'entrée 31 pour recevoir le signal d'information d'entrée et en dériver un signal d'amplitude dépendant du niveau de ce dernier signal,
- des moyens de traitement 38 couplés aux moyens d'évaluation 37, recevant le signal d'amplitude et en dérivant un signal de commande de gain selon une loi de commande de gain définie, lequel est transmis à l'entrée de commande de gain 51 des moyens d'amplification 33.

La figure 3 représente en outre un coupleur 36 partageant l'énergie du signal d'entrée entre la branche comprenant les moyens d'amplification 33 et celle qui contient les moyens d'évaluation 37 et de traitement 38.

Les moyens d'évaluation 37 peuvent être un simple détecteur d'enveloppe, tandis que les moyens de traitement 38 peuvent prendre diverses formes, comme exposé dans la demande conjointe.

Les moyens d'amplification à facteur d'amplification ajustable peuvent prendre la forme d'une chaîne d'étages d'amplification dans laquelle sont intercalés des étages d'atténuation commandables. Dans ce cas, le gain est ajusté par commande d'atténuateurs.

Ces moyens sont agencés de sorte que le niveau du signal de sortie possède une dynamique réduite par rapport à celle du signal d'entrée tel qu'il est illustré à la figure 2.

Le récepteur de la figure 3 comprend en outre une ligne à retard 34 ; elle est interposée entre l'entrée de signal 31 et les moyens d'amplification 33 et fournit à ces derniers un signal d'entrée retardé d'un temps tel que le signal de commande de gain est disponible pour la commande de gain dans les moyens d'amplification 33 au moment où ceux-ci reçoivent le signal d'entrée retardé.

Par ailleurs, la figure 3 représente également des moyens de filtrage 42. En effet, le signal d'entrée comprendra dans certains cas des signaux parasites hors bande qui affecteraient l'évaluation d'amplitude s'ils n'étaient pas éliminés. La solution est de les filtrer, par exemple par un filtrage passe-bande. On peut insérer un tel filtre entre l'entrée 31 et le point de couplage 36.

On se tournera maintenant vers la figure 4 pour expliquer brièvement quels sont les effets secondaires indésirables susceptibles d'être apportés par la ligne à retard 34 du récepteur de la figure 3.

On y a représenté des paquets successifs 61, 62, 63 observés à la sortie de la ligne à retard 34. Pour les besoins de la démonstration, on a choisi deux paquets de forte amplitude 61 et 63 encadrant un paquet de faible amplitude 62, dont le niveau est de 80 dB inférieur à celui des deux paquets adjacents 61 et 63.

En raison du couplage direct entre l'entrée de la ligne à retard 34 et sa sortie, le paquet 63 donne lieu à un effet secondaire indésirable qui est une réplique 631, atténuée de la valeur de l'isolation entrée/sortie (70 dB, dans l'exemple de la figure), en avance, car non retardée, et qui vient perturber la fin du paquet précédent 62, car elle est encore d'un niveau supérieur au sien.

En raison de la transmission multiple à travers la ligne à retard 34, le paquet 61 est lui-même suivi d'une réplique 611, atténuée d'une valeur plus ou moins importante suivant la qualité de la ligne à retard (habituellement de 30 à 50 dB, 50 dB à titre d'exemple sur la figure), en retard de trois fois le délai de traversée de la ligne à retard, qui vient perturber le début du paquet 62.

Dans de telles conditions, on voit que les paquets ne sont pas admissibles, car trop perturbés par les paquets de forte amplitude qui peuvent les encadrer. Une solution coûteuse est de soigner le découplage entrée/sortie et les adaptations à l'entrée et à la sortie de la ligne, ce qui est onéreux et laisse néanmoins subsister des effets perturbateurs.

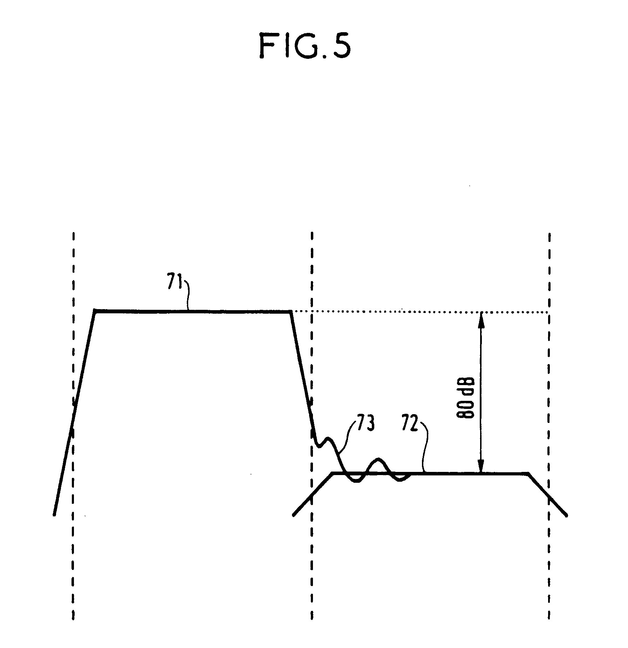

La figure 5 représente de la même façon comment le filtre 42 du récepteur de la figure 3 est susceptible de produire un effet secondaire indésirable, en l'occurrence une sur-oscillation 73 telle qu'un paquet de forte amplitude 71 perturbe un paquet de faible amplitude 72. Les mesures à prendre sont là encore coûteuses et partiellement satisfaisantes seulement.

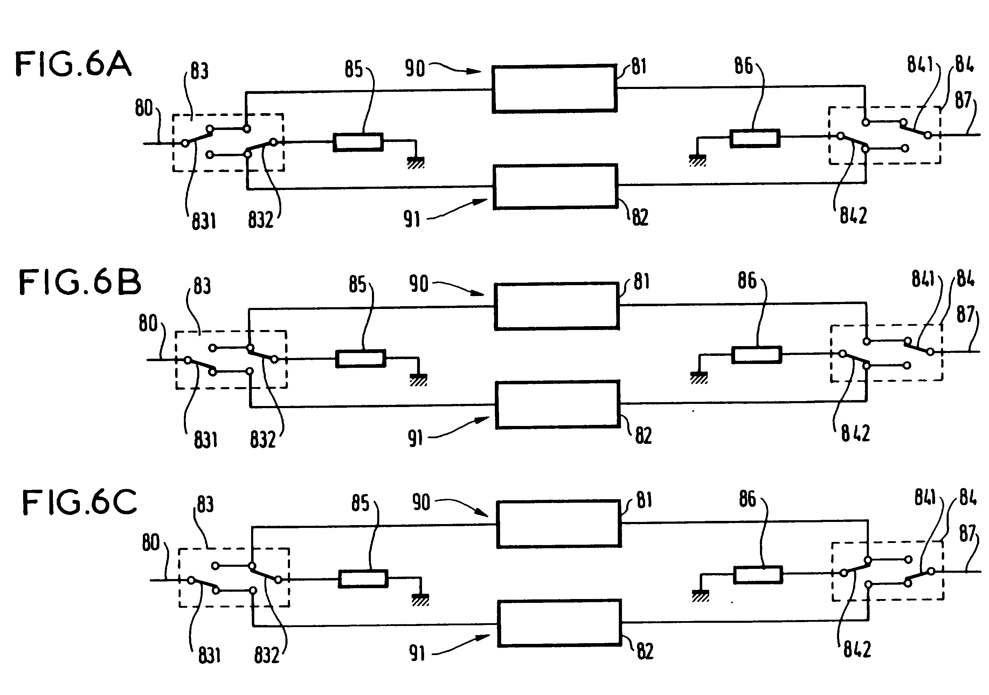

L'invention propose donc une autre solution qui sera maintenant décrite en se reportant d'abord aux figures 6A, 6B et 6C. Elle consiste en ce que deux éléments de traitement à effets secondaires 81, 82 sont disposés dans des voies séparées et en ce que des moyens de commutation 83, 84 connectent cycliquement les voies séparées à l'entrée de paquets 80 et à la sortie de paquets 87, chacune durant un intervalle de temps correspondant à un paquet, et les déconnectent entre temps de l'entrée de paquets 80 et de la sortie de paquets 87 de façon qu'une voie connectée pour le traitement d'un paquet ne puisse être perturbée par des paquets adjacents, chacun traité par une autre voie.

Dans un premier exemple, le dispositif de traitement de la figure 6A est destiné à remplacer la ligne à retard 34 du récepteur de la figure 3. Il comprend une entrée de paquets 80, un commutateur amont 83, deux voies séparées 90, 91, un commutateur aval 84 et une sortie de paquets 87. Dans le récepteur de la figure 3, l'entrée de paquets 80 serait connectée au dispositif de couplage 36 et la sortie de paquets 87 aux moyens d'amplification 33.

Dans un deuxième exemple, le dispositif de traitement de la figure 6A est destiné à remplacer le filtre passe-bande très sélectif 42 du récepteur de la figure 3. L'entrée et la sortie de paquets sont alors connectées en conséquence, tandis que les éléments de traitement 81 et 82 sont deux filtres tels que le filtre 42 de la figure 3.

Les figures 6B et 6C représentent le même dispositif que la figure 6A, les commutateurs 83 et 84 étant dans des positions différentes.

Les commutateurs 83 et 84 étant dans les positions représentées à la figure 6A, la voie 90 est en service, tandis que la voie 91 ne l'est pas. Un paquet est traité par la voie 90. Le paquet précédent a été traité par la voie 91 et le paquet suivant sera aussi traité par la voie 91. Comme la voie 91 n'est pas en circuit, ni le paquet précédent, ni le paquet suivant ne pourront perturber le paquet en cours de traitement. Il suffit pour cela que les commutateurs 83 et 84 soient manoeuvrés aux moments appropriés. Si le dispositif de la figure 6A correspond au filtre 42 de la figure 3, dont le temps de traversée peut être considéré comme nul, les commutateurs 83 et 84 peuvent être manoeuvrés ensemble, c'est à dire de manière synchrone, et quitter la position représentée à la figure 6A à la fin de la traversée d'un paquet, pour prendre directement la position illustrée à la figure 6C. La voie 91 est en service pour le paquet suivant à la place de la voie 90. La voie 90 déconnectée ne peut perturber ce paquet suivant, et ainsi de suite.

Si le dispositif de la figure 6A correspond à la ligne à retard 34 de la figure 3, les commutateurs amont et aval doivent fonctionner l'un après l'autre et, avant d'atteindre l'état de la figure 6C, ils passeront par l'état illustré à la figure 6B ; en effet, à la fin du paquet, observée au niveau du commutateur 83, celui-ci doit changer de position, alors que, à cause du retard apporté par la ligne à retard, ce n'est pas encore la fin du paquet au niveau du commutateur 84. C'est seulement après la fin du paquet traité par la voie 90, observée au niveau du commutateur 84, que l'état illustré par la figure 6C sera atteint. On notera que la déconnexion de l'entrée de la voie 90, dès la fin du paquet, empêchera que le paquet suivant ne vienne perturber la fin du paquet traité par cette voie 90, par couplage entrée/sortie à travers l'élément 81. De même, le couplage entrée/sortie à travers l'élément 82 n'aura pas d'effet perturbateur, puisque la sortie de l'élément 82 n'est pas encore connectée (voir figure 6B). Ensuite, la sortie de la voie 90 étant déconnectée dès la fin du paquet qu'elle vient de traiter (voir figure 6C), la réplique éventuelle trois fois retardée ne pourra pas avoir non plus d'effet perturbateur.

Par ailleurs, le commutateur 83 comprend deux inverseurs 831 et 832, tandis que le commutateur 84 comprend deux inverseurs 841 et 842. Les inverseurs 831 et 841 servent à connecter et déconnecter les voies séparées 90 et 91 comme on vient de le décrire. Additionnellement, les inverseurs 832 et 842 ont pour objet de connecter la voie non connectée à une charge dissipative respective, 85 et 86. Une telle disposition permettra de dissiper rapidement l'énergie contenu dans l'élément de traitement non connecté, afin qu'elle ne risque pas de causer une perturbation ultérieure.

Enfin, si l'on observe que les figures 6A, 6B et 6C, concernent le cas où il est prévu deux voies séparées, ce qui suppose que l'effet perturbateur éventuel d'une voie ne peut s'étendre plus loin que la durée d'un paquet - ce qui est conforme d'ailleurs à ce qu'illustrent les figures 4 et 5 - l'invention s'appliquerait tout aussi bien au cas où trois voies ou plus seraient nécessaires, moyennant des aménagements de commutateurs à la portée de l'homme de métier.

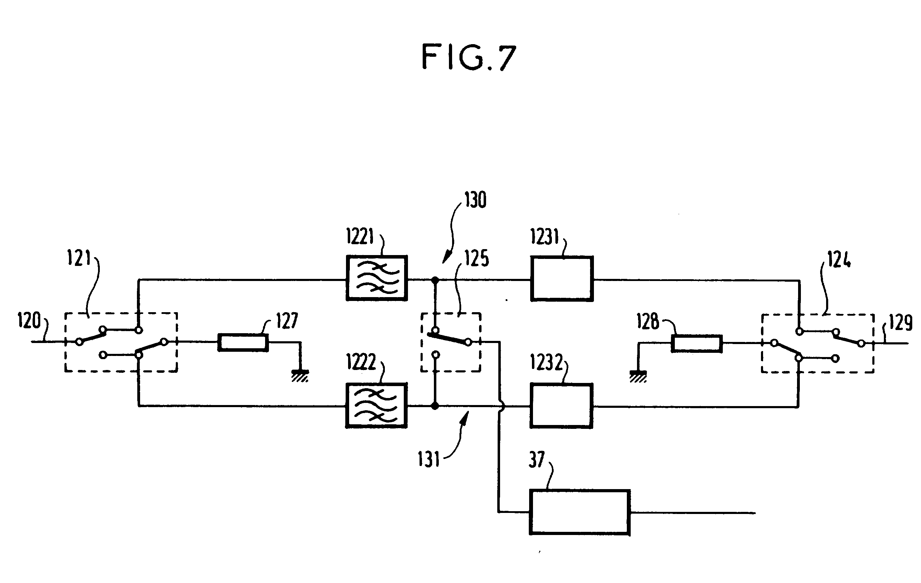

On décrira finalement, en se reportant à la figure 7, un mode de réalisation de l'invention combinant les moyens relatifs aux éléments de traitement 34 et 42 du récepteur de la figure 3.

Un seul dispositif de traitement comprend, conformément à celui des figures 6A, 6B, 6C, une entrée 120, un commutateur amont 121, deux voies séparées 130 et 131, un commutateur aval 124, avec les charges dissipatives 127 et 128, ainsi qu'une sortie 129. Chaque voie séparée comprend un filtre 1221, 1222, ainsi qu'une ligne à retard 1231, 1232. Le fonctionnement de cet ensemble se déduit directement de ce que l'on vient de décrire en relation avec les figures 6A, 6B et 6C. Additionnellement, pour le raccordement du dispositif d'évaluation 37, un commutateur 125 permet de prélever une partie de l'énergie de chaque paquet dans la voie où il est à chaque fois traité.

## Revendications

1. Dispositif de traitement de signaux se présentant sous forme de paquets successifs, transmis dans des intervalles de temps successifs, du type comprenant une chaîne de traitement incluant au moins un élément de traitement à effets secondaires (34, 81, 82, 1221, 1222, 1231, 1232) susceptible d'engendrer des perturbations affectant des paquets adjacents, caractérisé en ce qu'il comprend au moins deux éléments (81, 82 1231, 1232) de traitement à effets secondaires disposés dans des voies (90, 91, 130, 131) séparées, ainsi que des moyens de commutation (83, 84, 121, 124) connectant cycliquement lesdites voies séparées à une entrée de paquets (80, 120) et à une sortie de paquets (87, 129), chacune durant un intervalle de temps, et les déconnectant entre temps de ladite entrée de paquets (80, 120) et de ladite sortie de paquets (87, 129) de façon qu'une voie (90, 91, 130, 131) connectée pour le traitement d'un paquet ne puisse être perturbée par des paquets adjacents, chacun traité par une autre voie (90, 91, 130, 131).

2. Dispositif selon la revendication 1, caractérisé en ce que lesdits moyens de commutation (83, 84, 121, 124) comprennent un commutateur (83, 121) amont connectant sélectivement et cycliquement une entrée de paquets (80, 120) à une entrée de l'une de l'ensemble desdites voies séparées et un commutateur aval (84, 124) connectant sélectivement et cycliquement une sortie de l'une desdites voies séparées à une sortie de paquets (87, 129).

3. Dispositif selon la revendication 2, caractérisé en ce que lesdits commutateurs aval (84, 124) accomplissent leurs opérations de commutation vers les mêmes voies que les commutateurs amont (83, 121), mais avec un décalage dans le temps qui correspond au temps de transit des signaux dans une desdites voies séparées (90, 91).

4. Dispositif selon l'une des revendications 1 à 3, caractérisé en ce que lesdits moyens de commutation (83, 84, 121, 124) sont agencés non seulement pour la connexion sélective de l'une desdites voies séparées (90, 91, 130, 131), mais aussi pour fournir à toute voie non sélectionnée une charge dissipative (85, 86, 127, 128).

5. Dispositif selon l'une des revendications 1 à 4, caractérisé en ce que lesdits éléments à effets secondaires comprennent une ligne à retard (34, 1231, 1232).

6. Dispositif selon l'une des revendications 1 à 5, caractérisé en ce que lesdits éléments à effets secondaires comprennent un filtre à bande étroite (42, 1221, 1222).

7. Dispositif selon l'une des revendications 1 à 6, caractérisé en ce que le nombre desdites voies séparées (90, 91, 130, 131) est deux, et en ce que ces deux voies séparées sont utilisées alternativement par le moyen de commutateurs inverseurs (83, 84,121, 124).

## Patentansprüche

1. Vorrichtung zur Verarbeitung von in Form von aufeinanderfolgenden Paketen vorliegenden Signalen, die in aufeinanderfolgenden Zeitintervallen übertragen werden, mit einer Verarbeitungskette, die mindestens ein Verarbeitungselement mit Sekundärwirkungen (34, 81, 82, 1221, 1222, 1231, 1232) aufweist, d.h. Störungen erzeugen kann, welche benachbarte Pakete stören, dadurch gekennzeichnet, daß sie mindestens zwei Verarbeitungselemente (81, 82, 1231, 1232) mit Sekundärwirkungen in getrennten Kanälen (90, 91, 130, 131) sowie Schaltmittel (83, 84, 121, 124) aufweist, die zyklisch die getrennten Kanäle mit einem Paketeingang (80, 120) und einem Paketausgang (87, 129) verbinden, und zwar jeden während eines Zeitintervalls, und sie zwischenzeitlich von diesem Paketeingang (80, 120) und diesem Paketausgang (87, 129) trennen, so daß ein für die Verarbeitung eines Pakets angeschlossener Kanal (90, 91, 130, 131) nicht von benachbarten Paketen gestört werden kann, die von unterschiedlichen Kanälen (90, 91, 130, 131) verarbeitet werden.

2. Vorrichtung nach Anspruch 1, dadurch gekennzeichnet, daß die Schaltmittel (83, 84, 121, 124) einen vorne liegenden Schalter (83, 121), der selektiv und zyklisch einen Paketeingang (80, 120) mit einem Eingang eines Kanals der Gruppe von getrennten Kanälen verbindet, und einen hinten liegenden Schalter (84, 124) aufweisen, der selektiv und zyklisch einen Ausgang eines der getrennten Kanäle mit dem Paketausgang (87, 129) verbindet.

3. Vorrichtung nach Anspruch 2, dadurch gekennzeichnet, daß die hinten liegenden Schalter (84, 124) ihre Schaltoperation zu den gleichen Kanälen durchführen wie die vorne liegenden Schalter (83, 121), aber mit einer Zeitverzögerung, die der Laufzeit der Signale in einem der getrennten Kanäle (90, 91) entspricht.

4. Vorrichtung nach einem der Ansprüche 1 bis 3, dadurch gekennzeichnet, daß die Schaltmittel (83, 84, 121, 124) nicht nur für die selektive Verbindung eines der getrennten Kanäle (90, 91, 130, 131), sondern auch dafür ausgebildet sind, an jeden nicht ausgewählten Kanal eine Lastimpedanz (85, 86, 127, 128) anzuschließen.

5. Vorrichtung nach einem der Ansprüche 1 bis 4, dadurch gekennzeichnet, daß die Elemente mit Sekundärwirkungen eine Verzögerungsleitung (34, 1231, 1232) enthalten.

6. Vorrichtung nach einem der Ansprüche 1 bis 4, dadurch gekennzeichnet, daß die Elemente mit Sekundärwirkungen ein schmalbandiges Filter (42, 1221, 1222) enthalten.

7. Vorrichtung nach einem der Ansprüche 1 bis 6, dadurch gekennzeichnet, daß es zwei getrennte Kanäle (90, 91, 130, 131) gibt und daß diese beiden getrennten Kanäle alternativ über Umschalter (83, 84, 121, 124) verwendet werden.

## Claims

1. Device for processing signals in the form of successive packets sent in successive time slots of the type comprising a processing system including at least one processing member with secondary effects (34, 81, 82, 1221, 1222, 1231, 1232) likely to generate disturbances affecting adjacent packets characterised in that it comprises at least two processor members (81, 82, 1231, 1232) with secondary effects disposed in separate channels (90, 91, 130, 131) and switching means (83, 84, 121, 124) cyclically connecting said separate channels to a packet input (80, 120) and a packet output (87, 129) each during one time slot and disconnecting them between times from said packet input (80, 120) and said packet output (87, 129) so that a channel (90, 91, 130, 131) connected to process a packet cannot be disturbed by adjacent packets each processed by another channel (90, 91, 130, 131).

2. Device according to claim 1 characterised in that said switching means (83, 84, 121, 124) comprise an upstream switch (83, 121) selectively and cyclically connecting a packet input (80, 120) to an input of one of said separate channels and a downstream switch (84, 124) selectively and cyclically connecting an output of one of said separate channels to a packet output (87, 129).

3. Device according to claim 2 characterised in that said downstream switches (84, 124) switch to the same channels as the upstream switches (83, 121) but with a time difference which represents the propagation time of signals in one of said separate channels (90, 91).

4. Device according to any one of claims 1 to 3 characterised in that said switching means (83, 84, 121, 124) are adapted not only to connect selectively one of said separate channels (90, 91, 130, 131) but also to connect a dissipative load (85, 86, 127, 128) to each unselected channel.

5. Device according to any one of claims 1 to 4 characterised in that said members with secondary effects comprise a delay line (34, 1231, 1232).

6. Device according to any one of claims 1 to 5 characterised in that said members with secondary effects comprise a narrowband filter (42, 1221, 1222).

7. Device according to any one of claims 1 to 6 characterised in that the number of said separate channels (90, 91, 130, 131) is two and in that said two separate channels are used alternately by means of changeover switches (83, 84, 121, 124).
